Europäisches Patentamt

European Patent Office

Office européen des brevets

(11) Numéro de publication : **0 357 480 B1**

(12) **FASCICULE DE BREVET EUROPEEN**

(45) Date de publication du fascicule du brevet :
**12.10.94 Bulletin 94/41**

(51) Int. Cl.⁵ : **H01L 39/24, H01L 39/14, H01B 12/00, C04B 35/00**

(21) Numéro de dépôt : **89402174.0**

(22) Date de dépôt : **31.07.89**

(54) **Eléments composites comportant un coeur en matériau supraconducteur et leur procédé de préparation.**

(30) Priorité : **02.08.88 FR 8810420**

(43) Date de publication de la demande :
**07.03.90 Bulletin 90/10**

(45) Mention de la délivrance du brevet :
**12.10.94 Bulletin 94/41**

(84) Etats contractants désignés :
**DE GB**

(56) Documents cités :
**EP-A- 0 285 319**
**WO-A-88/08618**
**ADVANCED CERAMIC MATERIALS, vol. 2, no. 3B, Special Issue, 1987, pages 388-400, ACerS; R.W. McCALLUM et al.: "Problems in the production of YBa2Cu3Ox superconducting wire"**

(56) Documents cités :
**APPL. PHYS. LETT., vol. 51, no. 3, 20 juillet 1987, pages 203-204, American Institute of Physics; S. JIN et al.: "High Tc superconductors-composite wire fabrication"**
**JAPANESE JOURNAL OF APPLIED PHYSICS, vol. 26, no. 10, octobre 1987, pages 1653-1656; O. KOHNO et al.: "Critical current density of Y-Ba-Cu oxide wires"**

(73) Titulaire : **COMMISSARIAT A L'ENERGIE ATOMIQUE**
**31/33, rue de la Fédération**
**F-75015 Paris Cédex 15 (FR)**

(72) Inventeur : **Drifford, Maurice**
**2 rue de Chalais**
**F-94240 L'Hay Les Roses (FR)**
Inventeur : **Lambard, Jacques**
**72 rue de Chalais**
**F-94240 L'Hay Les Roses (FR)**

(74) Mandataire : **Mongrédien, André et al**
**c/o BREVATOME**
**25, rue de Ponthieu**
**F-75008 Paris (FR)**

## Description

La présente invention a pour objet la préparation d'éléments composites supraconducteurs comportant un coeur en matériau supraconducteur et une enveloppe externe métallique.

De façon plus précise, elle concerne des éléments composites à base de matériaux supraconducteurs dont les propriétés de supraconductivité peuvent être contrôlées par diffusion d'un gaz.

C'est le cas en particulier des matériaux céramiques supraconducteurs comportant des anions dont le nombre et la position dans la structure cristalline du matériau sont responsables des propriétés supraconductrices. Ces anions sont notamment des atomes d'oxygène et les supraconducteurs concernés sont par exemple les composés supraconducteurs à haute température critique à base d'oxyde de cuivre qui sont supraconducteurs à la température de l'azote liquide (77K), ce qui présente des avantages techniques et économiques considérables par rapport à l'emploi des supraconducteurs de type métallique où il est nécessaire d'opérer à la température de l'hélium liquide (4K).

Ces supraconducteurs peuvent être utilisés dans le domaine de l'électronique et de l'électrotechnique. Dans ce dernier domaine, des perspectives importantes sont ouvertes concernant les champs magnétiques intenses pour la recherche et l'instrumentation, par exemple dans le domaine médical, l'électrotechnique industrielle (alternateurs et transformateurs supraconducteurs) et le transport de l'énergie pour des liaisons à supraconducteurs sans perte d'énergie, qui remplaceraient les câbles à haute tension.

Pour toutes ces applications, il est nécessaire de réaliser des fils, filaments ou rubans, mais ceci pose certains problèmes en raison de la fragilité naturelle des matériaux céramiques supraconducteurs et de la nécessité d'obtenir une composition chimique et une texture particulière pour que le matériau soit supraconducteur. Par ailleurs, il existe certains problèmes de vieillissement du matériau par les agents atmosphériques.

Diverses techniques ont été proposées jusqu'à présent pour obtenir des fils, filaments ou rubans à partir de matériaux supraconducteurs de ce type. Parmi celles-ci, les techniques les plus intéressantes et les plus largement utilisées consistent à partir d'une poudre du matériau supraconducteur, à introduire cette poudre dans un tube étanche mais perméable à l'oxygène, réalisé par exemple en argent, à soumettre ensuite le tube à une opération de rétreint pour former un fil ou un ruban et à soumettre ensuite le fil ou le ruban ainsi obtenu à un frittage à chaud, puis à un traitement thermique en atmosphère d'oxygène pour restaurer ou améliorer les propriétés supraconductrices du matériau. Des procédés de ce type sont décrits en particulier par R.W. Mc Callum dans Advanced Ceramic Materials, vol. 2, n° 3B, 1987, p. 388-395 ; et B. A. Glowacki dans MRS Boston, décembre 1987, Paper AA7. 35 et dans Proc. Europ. Workshop High Tc Supra Genova 1987 - Paper 89.

Dans ces procédés, la diffusion d'oxygène dans le produit qui a été soumis à l'opération de rétreint, est destinée à réaliser l'occupation des sites du réseau anionique dans le cristal du matériau supraconducteur, qui fera passer le matériau de l'état isolant à celui de supraconducteur. En effet, cet ajustement du réseau anionique après l'élaboration de l'élément est nécessaire car, au cours des traitements de rétreint à chaud et de frittage, le matériau supraconducteur perd certains de ses anions qui sont indispensables pour obtenir la supraconductivité.

Dans ces procédés, on réalise la diffusion de l'oxygène au travers d'un tube qui autorise la diffusion de l'oxygène, par exemple au travers d'un tube d'argent qui est mécaniquement ductile pour permettre l'opération de rétreint, qui a une bonne résistance à la corrosion sous oxygène à haute température et une capacité élevée de solubiliser l'oxygène puisqu'on dissout 1cm$^3$ d'oxygène dans les conditions normales de température et de pression pour 1kg d'argent sous 10$^5$Pa d'oxygène à 400°C.

Toutefois, l'utilisation d'un tube en argent présente certains inconvénients. En effet, l'argent a une température de fusion assez basse, notamment sous atmosphère d'oxygène (939°C sous 10$^5$Pa), ce qui limite la température susceptible d'être utilisée pour le frittage et l'opération de diffusion d'oxygène. L'argent est un métal qui ne permet pas d'obtenir une bonne compacité du matériau supraconducteur dans le tube lors de l'opération de rétreint ; par ailleurs, il est trop plastique notamment quand le tube est mince, c'est-à-dire qu'il rend possible le développement de défauts transverses dans le matériau supraconducteur tels que des fissures. De plus, l'argent ne présente pas des propriétés mécaniques suffisantes pour conférer à l'élément obtenu une bonne tenue mécanique.

De ce fait, les performances des éléments tels que des fils, filaments ou rubans supraconducteurs préparés par ces procédés restent très inférieures à celles des supraconducteurs de type classique actuellement utilisés et inférieures également à ce que l'on peut réaliser avec des couches minces de matériau céramique supraconducteur à base d'oxyde de cuivre.

Pour éviter certains de ces inconvénients, on a envisagé de remplacer le tube en argent par un tube métallique réalisé en d'autres métaux, mais ceci pose d'autres problèmes car ces métaux ne permettent pas de réaliser la diffusion de l'oxygène et/ou interagissent chimiquement avec le matériau supraconducteur, ce qui conduit à une certaine dégradation des propriétés supraconductrices.

Ainsi des métaux nobles tels que le platine et le palladium sont attaqués par l'oxyde supraconducteur à partir de 1000°C ; le cuivre ne peut convenir car lors des opérations de rétreint et de frittage, l'oxydation du tube en cuivre se fait au détriment de l'oxyde supraconducteur qui devient semiconducteur dès que l'ensemble est chauffé à 200-300°C.

De plus, pour améliorer les performances du matériau supraconducteur, il est important d'assurer lors du frittage une bonne densification de la poudre et le tube devra ainsi contribuer à l'obtention d'un tel résultat.

La demande de brevet européen EP-A- 0 285 319 publiée le 5 octobre 1988 qui appartient à l'état de la technique selon l'Article 54(3) CBE et n'est donc à considérer que pour la nouveauté de la présente invention, décrit un élément supraconducteur comprenant une poudre d'oxyde entourée d'une barrière de diffusion réalisée par exemple en argent et d'une gaine métallique par exemple en cuivre, qui peut être munie de perforations pour permettre la diffusion d'oxygène dans la poudre lors d'un traitement thermique ultérieur del'élément.

La présente invention a précisément pour objet un élément composite comportant un coeur en matériau supraconducteur et une enveloppe métallique ayant certaines caractéristiques qui permettent d'assurer la diffusion d'un gaz dans le coeur et d'améliorer les performances supraconductrices de l'élément tout en assurant une bonne tenue mécanique de l'ensemble.

Selon l'invention, l'élément composite comporte un coeur en matériau supraconducteur céramique ou capable de devenir supraconducteur et une enveloppe métallique disposée autour du coeur, et il se caractérise en ce que l'enveloppe a une structure composite autorisant la pénétration à travers celle-ci d'un gaz à diffuser dans le coeur et en ce qu'elle comprend au moins deux régions réalisées en des métaux ou des alliages différents, l'une des régions dite première région formant une barrière chimique entre le coeur et la ou les autres régions, et la ou les autres régions ayant des modules d'élasticité plus élevés que ceux du matériau supraconducteur, à condition que cette structure composite ne soit pas constituée par deux couches concentriques dont une première couche en métal ou alliage non poreux, perméable au gaz à diffuser, disposée autour du coeur, et une deuxième couche présentant une porosité ouverte.

L'utilisation d'une enveloppe composite présentant les caractéristiques décrites ci-dessus permet d'assurer dans de bonnes conditions la diffusion d'un gaz dans le coeur de l'élément lors de sa fabrication, de conférer à l'ensemble de bonnes propriétés mécaniques grâce au choix de métaux ou d'alliages ayant de bonnes caractéristiques élastiques pour réaliser certaines régions de l'enveloppe, et d'éviter les réactions chimiques indésirables entre le matériau supraconducteur du coeur et le métal ou l'alliage de l'enveloppe responsable des propriétés mécaniques.

Selon un premier mode de réalisation de l'invention, l'enveloppe comprend uniquement deux régions qui sont étroitement liées entre elles pour former une seule couche autour du coeur de l'élément.

Dans ce cas, la première région est le moyen qui permet à la fois d'assurer la diffusion d'un gaz dans le coeur et de réaliser une barrière chimique entre le coeur et la deuxième région. Cette première région peut être constituée par un métal ou un alliage non poreux, perméable au gaz à diffuser et la seconde région est alors dispersée à l'intérieur de la première région afin d'être enrobée complètement par celle-ci, pour éviter tout contact avec le coeur.

Selon une variante de ce premier mode de réalisation, on peut utiliser une première région présentant une porosité ouverte et une seconde région dispersée dans la première région de façon à être également enrobée complètement dans celle-ci comme précédemment.

Dans le premier cas, le métal ou l'alliage utilisé pour la première région doit non seulement être perméable aux gaz à diffuser, mais constituer également une barrière chimique efficace entre le coeur et la deuxième région, être compatible chimiquement avec le supraconducteur, avoir une tenue chimique acceptable vis-à-vis du gaz à diffuser, et avoir une température de fusion supérieure à la température de frittage du matériau supraconducteur.

Lorsque le gaz à diffuser est de l'oxygène pour des matériaux supraconducteurs à base d'oxydes mixtes de cuivre, on peut utiliser l'argent, le palladium, le chrome, le cobalt, le tantale et leurs alliages, notamment les alliages d'argent ou de palladium.

De préférence, on utilise l'argent car celui-ci présente une bonne transparence à l'oxygène, des propriétés mécaniques favorables lorsqu'on réalise l'élément composite par un procédé comportant une opération d'étirage, de bonnes propriétés électriques puisque sa résistivité est de $10^{-6}$ ohms.cm, et un coût modéré vis-à-vis des autres métaux nobles. De plus, l'argent est compatible avec les matériaux supraconducteurs à base d'oxydes mixtes de cuivre car il constitue un poison acceptable pour ces matériaux puisqu'il peut prendre la place du cuivre dans la maille, ce qui a seulement pour effet de diminuer le volume supraconducteur de l'élément. Enfin, la transparence de l'argent vis-à-vis de l'oxygène est très supérieure à celle des autres métaux présentant une solubilité notable pour l'oxygène comme le chrome, le cobalt, le tantale ou le palladium.

Dans le second cas, c'est-à-dire lorsque la première région est réalisée en métal ou alliage à porosité ouverte entre le coeur et l'extérieur de l'enveloppe, on choisit un métal ou alliage ayant la propriété de constituer une bonne barrière chimique entre le coeur et le reste de l'enveloppe, d'être compatible avec le supraconducteur et d'avoir une tenue chimique acceptable vis-à-vis du gaz à diffuser. Dans ce cas, on utilise généralement des métaux nobles tels que l'or, l'argent, le platine, le palladium ou leurs alliages, ayant des points de fusion supérieurs à la température de frittage du matériau de coeur. Les alliages peuvent être en particulier des alliages d'argent avec des métaux précieux ou des platinoïdes.

Selon l'invention, les métaux ou alliages constituant chacune des deux régions de la couche enveloppe sont choisis de façon telle que l'enveloppe ait un coefficient de dilatation linéaire voisin de celui du supraconducteur, et qu'ils assurent la tenue mécanique de l'ensemble. Pour cette fonction, le rôle principal est tenu par la deuxième région qui doit être compatible avec le métal ou l'alliage qui constitue la barrière chimique, dans les conditions de fabrication de l'élément composite.

Ainsi, il est important que le métal ou l'alliage de la deuxième région ne diffuse pas dans la barrière chimique, ou que cette diffusion soit faible dans les conditions de fabrication de l'élément composite, et ne soit pas fusible aux températures de fabrication de l'élément composite.

En ce qui concerne les propriétés mécaniques, ce métal ou alliage doit avoir de meilleures caractéristiques élastiques que le matériau supraconducteur telles qu'elles sont définies par la théorie de l'élasticité. Le métal ou alliage de la deuxième région doit présenter des modules d'élasticité supérieurs à ceux du matériau supraconducteur, modules mesurés à la température ambiante. Il s'agit du module d'élasticité longitudinal appelé module d'Young et du module d'élasticité transversal appelé module de Coulomb qui a un comportement similaire au module d'Young pour ces matériaux. On demande aussi à ce que le métal ou alliage de la deuxième région présente une limite de rupture supérieure à celle du matériau supraconducteur, et de préférence que ce métal ou alliage présente plus longtemps que le matériau supraconducteur un comportement élastique lorsqu'il est soumis à un effort croissant, ce qui entraîne une plus grande valeur de la limite élastique du métal ou alliage de la deuxième région que celle du supraconducteur.

On demande aussi que le métal ou alliage de la deuxième région présente des caractéristiques élastiques supérieures à celles du métal ou alliage de la première région, c'est-à-dire les modules d'Young et de Coulomb, ainsi que la limite d'élasticité.

Il est nécessaire enfin que l'alliage ou le métal utilisé soit un bon conducteur électrique et un bon conducteur thermique.

A titre d'exemples de métaux ou d'alliages susceptibles d'être utilisés pour la deuxième région, en particulier avec un matériau supraconducteur à base d'oxyde mixte de cuivre, on peut citer le nickel, le cuivre, le fer, les aciers inoxydables comme les aciers au nickel-chrome à structure austénitique, par exemple les aciers à 18% de chrome et 8% de nickel et les aciers inoxydables à haute teneur en nickel contenant du chrome et/ou de l'aluminium, les alliages nickel-chrome, les alliages nickel-cuivre, le molybdène, le tungstène, le vanadium, le tantale, le rhénium, le rhodium, l'iridium, le ruthénium et leurs alliages.

Selon un deuxième mode de réalisation de l'invention, l'enveloppe composite comprend deux régions disposées en couches concentriques autour du coeur. Dans ce cas, la première région forme une première couche en contact avec le coeur et elle est réalisée en métal ou alliage à porosité ouverte. La deuxième région forme une seconde couche autour de la première couche et présente une porosité ouverte.

Selon une variante de ce second mode de réalisation, le coeur en matériau supraconducteur est formé de plusieurs éléments en matériau supraconducteur séparés les uns des autres par un métal ou alliage perméable au gaz à diffuser.

Généralement, le métal ou alliage perméable est le même que celui de la première région.

Le métal ou alliage utilisé pour réaliser la première région peut être l'un de ceux utilisés dans le premier mode de réalisation pour la première région. En effet, de même que précédemment, le métal ou alliage doit être perméable aux gaz à diffuser, compatible avec le supraconducteur en constituant simultanément une bonne barrière chimique, ou simplement constituer une barrière chimique.

Les métaux ou alliages utilisés pour la deuxième région doivent répondre également aux caractéristiques mentionnées ci-dessus en ce qui concerne la deuxième région du premier mode de réalisation.

Dans ce deuxième mode de réalisation, la première région peut être réalisée en métal ou alliage à porosité ouverte. Dans ce cas, on utilise un métal ou alliage parmi ceux utilisés dans la variante du premier mode de réalisation. En effet, de même que précédemment, le métal ou alliage doit constituer une barrière chimique entre le coeur et le reste de l'enveloppe, et être compatible chimiquement avec le supraconducteur. De préférence, on choisit des métaux inertes vis-à-vis du gaz à diffuser, ou dont la réactivité est jugée acceptable dans les conditions de fabrication du composite supraconducteur.

Selon un troisième mode de réalisation de l'invention, l'enveloppe comprend trois régions dont une première et une deuxième régions agencées entre elles pour former une première couche entourant le coeur de l'élément composite, et une troisième région présentant une porosité ouverte et formant une seconde couche autour de la première couche.

Dans ce cas, la première couche peut être réalisée de la même façon que l'enveloppe à couche unique du premier mode de réalisation, la seconde couche étant formée d'un métal ou d'un alliage présentant de bonnes propriétés mécaniques et une porosité ouverte pour permettre le passage du gaz à diffuser. Le métal ou alliage utilisé pour cette troisième région peut être identique ou différent du métal ou alliage utilisé pour former la deuxième région.

Dans ce troisième mode de réalisation, on peut aussi disposer une couche supplémentaire de métal ou alliage poreux ou perméable au gaz à diffuser entre le matériau supraconducteur et la première couche. Dans ce cas, il est nécessaire que cette couche supplémentaire soit compatible avec le matériau supraconducteur. Elle peut aussi constituer la barrière chimique soit la première région entre le matériau supraconducteur et les autres régions, et il n'est plus nécessaire dans ce cas que l'un des métaux ou alliages qui constitue la première couche, joue le rôle de barrière chimique.

Les éléments composites décrits ci-dessus peuvent être préparés par un procédé utilisant la technique de base du rétreint d'un tube rempli de poudre du matériau supraconducteur.

Selon l'invention, ce procédé comprend les étapes successives suivantes :

1°) introduire une poudre d'un matériau supraconducteur ou une poudre capable de former un matériau supraconducteur dans un tube métallique composite au travers duquel peut pénétrer un gaz apte à conférer à la poudre les propriétés de supraconductivité voulues, le tube comportant au moins deux régions réalisées en des métaux ou alliages différents, l'une des régions dite première région formant une barrière chimique entre la poudre introduite dans le tube et la ou les autres régions du tube, et la ou les autres régions ayant des modules d'élasticité supérieurs à ceux du matériau supraconducteur,

2°) sceller le tube à ses deux extrémités,

3°) soumettre le tube à un rétreint pour former l'élément composite,

4°) soumettre l'élément composite à un premier traitement thermique pour fritter la poudre de matériau supraconducteur, et à un second traitement de diffusion du gaz apte à conférer à la poudre les propriétés de supraconductivité voulues.

Selon l'invention, le premier et le second traitements peuvent être réalisés successivement ou simultanément. On peut en effet réaliser le frittage de la poudre supraconductrice en présence d'un gaz à diffuser dans le coeur que l'on continue de diffuser pendant le refroidissement de l'élément composite.

Dans ce procédé, l'utilisation d'un tube comportant au moins deux régions présentant les caractéristiques décrites ci-dessus permet d'obtenir un matériau supraconducteur compact qui aura dans le tube une meilleure tenue mécanique que les produits de l'art antérieur.

En effet, on choisit les métaux ou alliages du tube de façon à accompagner le matériau au cours du frittage, c'est-à-dire pendant sa phase naturelle de contraction par perte de porosité. On peut de plus assister cette opération en soumettant l'élément composite lors du frittage à l'action de la pression d'une pièce mécanique ou d'un gaz. Cette pression peut être appliquée sous la forme d'une compression uniaxiale qui permet la densification du matériau et l'orientation préférentielle des grains, cette propriété pouvant être mise à profit dans certains cas pour augmenter le courant critique du matériau supraconducteur. On peut aussi appliquer la pression par compression isostatique au moyen d'un gaz.

Le tube métallique à structure composite utilisé dans le procédé de l'invention peut être fabriqué par des procédés classiques.

Dans le premier mode de réalisation de l'invention, où le tube qui formera l'enveloppe est constitué de deux régions entremêlées, on peut réaliser ce tube à partir de poudres par des opérations de frittage. On peut aussi réaliser un tube métallique poreux à partir du ou des constituants qui formeront la deuxième région du tube en utilisant par exemple des techniques de compression et de frittage, et remplir ensuite les pores avec le métal ou l'alliage destiné à former la première région, en opérant par exemple par fusion si celui-ci est plus fusible que le tube métallique poreux de départ. Les poudres utilisées pour former le tube poreux peuvent avoir des dimensions de l'ordre de 1 à 1000um et se présenter sous la forme d'ovoïdes, de bâtonnets, de plaquettes, de dendrites, de filaments, permettant d'obtenir des porosités variant de 10 à 80%. En comblant ensuite les pores du tube par un métal plus fusible, le métal du tube poreux sera complètement inséré dans le métal plus fusible qui constituera à la fois la phase permettant la diffusion du gaz et la barrière chimique entre le matériau supraconducteur et le reste de l'enveloppe. Lorsqu'on veut conserver une certaine porosité, on utilise un tube métallique ayant des pores de dimensions plus importantes et l'on tapisse seulement l'intérieur des pores par le métal qui constituera la barrière chimique. Ceci peut être effectué par des procédés classiques, par exemple par dépôt chimique ou par galvanoplastie à partir de solutions d'un sel du métal à déposer, entraînées en circulation à travers le tube poreux. On peut aussi réaliser un tel tube en revêtant les grains de poudre utilisés pour la préparation du tube poreux par le métal qui constituera la barrière chimique et en frittant ensuite les grains revêtus.

Dans le deuxième mode de réalisation de l'invention où le tube métallique doit comporter deux couches coaxiales dont une couche externe poreuse, on peut utiliser des procédés classiques pour préparer un tel tube. Ainsi, on peut réaliser séparément les deux couches, puis les introduire l'une dans l'autre. On peut aussi partir d'un tube poreux qui constituera la couche externe et déposer par voie physique ou chimique à l'intérieur de ce tube, le métal ou l'alliage qui constituera la couche interne. Dans ce cas, on peut former la couche interne à partir d'une poudre, par exemple par compression isostatique. On peut encore réaliser un dépôt poreux externe par projection d'une matière en fusion sur un tube présentant les caractéristiques de la couche interne.

Avec ces modes de fabrication, la pénétration mutuelle des deux régions à l'interface entre les deux couches n'est pas exclue.

Dans le troisième mode de réalisation de l'invention, où le tube comporte au moins trois régions formant deux couches concentriques, on peut utiliser les techniques décrites ci-dessus et les combiner entre elles pour réaliser un tel tube.

Dans la première étape du procédé de l'invention, on introduit dans le tube à structure composite une poudre ou un mélange de poudres capable de former un matériau supraconducteur. Ainsi, on peut partir d'une poudre présentant déjà des propriétés de supraconductivité ou d'un mélange de poudres qui formeront un matériau supraconducteur après réaction.

Les poudres utilisées sont celles qui conviennent à la formation de supraconducteurs dont les propriétés peuvent être adaptées ou obtenues par diffusion d'un gaz. Lorsque la première région du tube présente une porosité ouverte, on choisit une dimension de poudre telle que l'on puisse obtenir une pénétration du matériau supraconducteur dans les pores accessibles de cette première région.

Le procédé s'applique en particulier aux supraconducteurs ayant une phase cristalline bâtie sur un réseau anionique et dans lesquels une certaine stoechiométrie d'une ou plusieurs espèces anioniques est nécessaire pour obtenir les propriétés supraconductrices.

On peut distinguer deux groupes :

- les supraconducteurs à haute température critique qui ne sont pas nécessairement des oxydes, pour lesquels il est nécessaire d'effectuer un ou des traitements gazeux spécifiques bien contrôlés pendant et/ou après le frittage. A titre d'exemple, le gaz peut être l'oxygène, et le matériau supraconducteur peut être un oxyde mixte appartenant aux familles LaSrCuO, YBaCuO, TlBaCaCuO, BiSrCaCuO et BaPbBiO. Le gaz peut être le fluor et le matériau supraconducteur peut appartenir aux familles YBaCuO, LaCuO. Le gaz peut être le soufre et le matériau supraconducteur peut appartenir au type YBaCuO.

- Les supraconducteurs à haute température critique qui sont des oxydes pour lesquels on souhaite préserver, contrôler, restaurer ou accroître le nombre d'anions oxygène par maille dans le but d'obtenir les performances voulues. A titre d'exemple, il peut s'agir d'oxydes mixtes appartenant aux familles LaSrCuO, La-BiSrCuO, TlBaCaCuO, BiSrCaCuO et YBaCuO.

L'invention s'applique en particulier aux oxydes mixtes de cuivre répondant à la formule :

$$M^1M^2_2Cu_3O_{7-\delta}$$

dans laquelle $M^1$ représente un ou plusieurs éléments des terres rares y compris l'yttrium, $M^2$ représente un ou plusieurs métaux alcalinoterreux choisis parmi Sr, Ca et Ba, et $\delta$ est tel que

$$0 \leq \delta \leq 0,4$$

A titre d'exemple de tels oxydes mixtes, on peut citer les oxydes de formule :

$$YBa_2Cu_3O_{7-\delta}$$

appelé YBaCuO.

Parmi ceux-ci, on préfère l'oxyde mixte de formule $YBa_2Cu_3O_{7-\delta}$ avec $0 \leq \delta \leq 0,1$.

L'invention s'applique aussi aux oxydes mixtes de cuivre correspondant aux familles connues sous les noms de TlBaCaCuO et BiSrCaCuO. A titre d'exemple, on peut citer les compositions $Bi_2Sr_{3-x}Ca_x\text{-}Cu_2O_{8+y}$ avec $0<x<1$ et $0<y<1$ et $Tl_2Ba_2Ca_2Cu_3O_{10}$. Pour former le coeur de l'élément en de tels matériaux supraconducteurs, on peut partir d'une poudre de l'oxyde mixte ou d'un mélange des poudres d'oxydes et/ou de carbonates constitutifs, par exemple d'oxyde de baryum, d'oxyde de cuivre et d'oxyde d'yttrium ou encore d'oxyde mixte de baryum et de cuivre et d'oxyde d'yttrium.

La poudre ou le mélange de poudres peut être introduit tel quel dans le tube métallique. Toutefois, on peut aussi soumettre tout d'abord la poudre ou le mélange de poudres à un précompactage avant de l'introduire dans le tube. Dans ce cas, on compacte la poudre sous la forme d'une préforme correspondant à la géométrie interne du tube métallique pour obtenir un élément que l'on introduit dans le tube sans jeu excessif. On peut obtenir cette préforme par compression isostatique à la température ambiante sous des pressions allant de 1 à $10^3$ MPa.

Lorsque le matériau supraconducteur présente une anisotropie, on peut remplir le tube avec des cristaux favorablement orientés pour le passage du courant selon l'axe du tube, si l'on sait préparer des cristaux dans une forme géométrique qui différencie cette anisotropie.

Ceci peut être effectué avec une poudre d'oxyde mixte de cuivre pour lequel le sens favorable à l'écoulement des charges correspond aux plans $CuO_2$ car lorsqu'on fait croître des cristaux de ces oxydes mixtes de cuivre sous une forme allongée, les plans $CuO_2$ correspondent à la plus grande direction des cristaux.

A titre d'exemple, on peut citer les oxydes mixtes appartenant aux familles YBaCuO, TlBaCaCuO et BiSrCaCuO.

On peut aussi orienter les cristaux anisotropes dans le tube en appliquant des forces électromagnétiques pour orienter les grains. Ceci peut être réalisé avec YBaCuO en appliquant lors du remplissage du tube un champ magnétique de sorte que les lignes de champ se trouvent perpendiculaires à l'axe de l'élément composite.

Après introduction de la poudre, on scelle le tube à ses deux extrémités, puis on procède à l'opération de rétreint. Cette opération peut être réalisée par les techniques connues d'étirage, d'extrusion, de laminage, d'emboutissage, de martelage ou de martelage-étirage.

Ces techniques qui permettent de réduire progressivement la section transversale du tube se font en maintenant sous pression la poudre céramique qui n'est pas encore consolidée et qui se comporte ainsi comme une poudre quasi fluide, ce qui conduira à une densité du matériau pulvérulent constante tout le long de l'élément composite obtenu. Généralement, on réalise successivement plusieurs opérations de rétreint pour obtenir la dimension transversale souhaitée.

Pour éviter les fluctuations de densité de remplissage du tube, on peut effectuer des opérations de recuit intermédiaires entre les opérations de rétreint en utilisant des températures relativement basses, par exemple d'environ 400°C, chaque fois que l'écrouissage du tube métallique deviendra excessif pour poursuivre les opérations de rétreint. On peut effectuer ces opérations de rétreint et de recuit à l'air ou dans une atmosphère appauvrie en oxygène.

Après ces opérations, on réalise un traitement thermique pour fritter la poudre introduite dans le tube. Ce traitement thermique est généralement réalisé sous une atmosphère qui contient au moins en partie le gaz à diffuser dans le matériau pour lui conférer les propriétés de supraconductivité voulues.

La température et la durée du traitement ainsi que l'atmosphère utilisées dépendent du matériau supraconducteur et des métaux ou alliages utilisés pour former l'enveloppe métallique. Dans le cas, où le matériau supraconducteur est un oxyde mixte de cuivre appartenant au type YBaCuO, la température est généralement de 900 à 1000°C, la durée peut aller de 1 à 24 heures sous des pressions partielles d'oxygène allant de $10^3$ à $10^5$Pa.

Selon une caractéristique avantageuse du procédé de l'invention, on réalise ce traitement en appliquant simultanément une pression à l'élément composite pour éviter qu'au cours du frittage de la poudre ou des cristaux, il y ait un retrait important du matériau céramique qui serait néfaste pour la tenue mécanique de l'élément obtenu. Dans ce cas, on place le tube sous pression à une température proche de la température maximale de frittage de manière à ce que le tube puisse suivre le déplacement du matériau de coeur. Ainsi, à la température de frittage, et proche de la température de frittage, le tube a un comportement plastique et suit la contraction du matériau de coeur.

L'application de la pression peut être effectuée par pressage isostatique. On peut aussi opérer par compression mécanique. Dans ce cas, lorsque l'enveloppe métallique est complètement poreuse, on peut évacuer les gaz occlus dans le matériau de coeur par la porosité. Généralement, on utilie des pressions de 10 à $10^3$MPa.

Après frittage, on refroidit l'ensemble à la température ambiante.

Lorsqu'on réalise une compression isostatique, on réalise de préférence le pressage isostatique au moyen d'un gaz neutre comme l'argon ou l'azote dopé par le gaz à diffuser dans le matériau de coeur.

Lorsqu'on réalise la compression par voie mécanique, on peut réaliser celle-ci par compression uniaxiale fournie par une presse. Dans ce cas, la forme des machoires sera adaptée à la géométrie de l'élément composite à traiter. On peut utiliser par exemple une mâchoire double V pour un élément cylindrique ou une mâchoire plate préformée pour un ruban.

Après frittage, on soumet l'élément à un traitement de diffusion d'un gaz apte à conférer au matériau de coeur les propriétés de supraconductivité voulues. Ce traitement est généralement réalisé à une température supérieure à la température ambiante lors du refroidissement de l'élément composite depuis la température de frittage à la température ambiante.

Selon un premier mode opératoire simple, le traitement est réalisé après le frittage pendant le refroidissement de l'élément composite. A titre d'exemple pour des oxydes de cuivre appartenant aux familles BiSrCaCuO, TlBaCaCuO et YBaCuO, l'atmosphère de traitement contiendra une pression partielle de 10 à $10^5$Pa d'oxygène, la vitesse moyenne de refroidissement de l'élément composite sera comprise entre 10 et $10^3$°C/h après une température maximale de frittage comprise entre 800 et 1000°C.

Selon un second mode opératoire, on opère ce traitement de diffusion à température constante et la température et la durée de cette opération sont choisies en fonction du matériau utilisé. On peut de préférence dans le cas de céramiques à base de YBaCuO opérer par exemple à des températures de 300 à 400°C, pendant des durées de 1 à 24h, sous une pression partielle de $10^2$ à $10^5$Pa d'oxygène et on peut simultanément appliquer à l'élément une pression comme c'était le cas lors du frittage. Dans le cas où l'on applique une pression par compression isostatique, on modifie la composition de la phase gazeuse utilisée pour la compression isostatique afin de disposer d'une quantité suffisante de gaz à diffuser.

Après ce traitement de diffusion, on peut, si on le désire, protéger l'élément composite de l'action néfaste des agents atmosphériques en disposant autour de celui-ci une gaine imperméable aux gaz.

En effet, la plupart des agents atmosphériques tels que l'eau, la vapeur d'eau et le $CO_2$ ont une action

néfaste sur les propriétés du matériau céramique supraconducteur car ils décomposent les oxydes du type $Y_1Ba_2Cu_3O_{7-\delta}$, en CuO, $Ba(OH)_2$, $BaCO_3$ et $Y_2BaCuO_5$ ce qui fait perdre au matériau ses propriétés de supraconductivité. Aussi, pour éviter la dégradation de l'élément par vieillissement, il est préférable de protéger celui-ci des agents chimiques par une gaine qui peut être réalisée de différentes façons.

Ainsi, on peut utiliser une gaine métallique que l'on dépose par un procédé à température relativement basse, par exemple inférieure à 300°C, pour ne pas modifier les propriétés du matériau supraconducteur céramique. Ceci peut être effectué par des méthodes de dépôt physique, de dépôt chimique en phase vapeur ou par des méthodes d'immersion dans un métal en fusion.

On peut aussi utiliser une gaine en produit organique par exemple en polymère fluoré ou chlorofluoré ou en résine époxy-acrylate polymérisable sous ultraviolet.

On peut encore utiliser une gaine en matériau inorganique vitrifiable.

D'autres caractéristiques et avantages de l'invention apparaîtront mieux à la lecture des exemples suivants donnés bien entendu à titre illustratif et non limitatif en référence au dessin annexé sur lequel :

- la figure 1 représente en coupe transversale un élément composite conforme au premier mode de réalisation de l'invention,
- la figure 2 représente en coupe transversale un élément composite conforme au second mode de réalisation de l'invention,
- la figure 3 représente en coupe transversale un élément composite conforme à la variante du second mode de réalisation, et
- la figure 4 représente en coupe transversale un élément composite conforme au troisième mode de réalisation de l'invention.

**Exemple 1.**

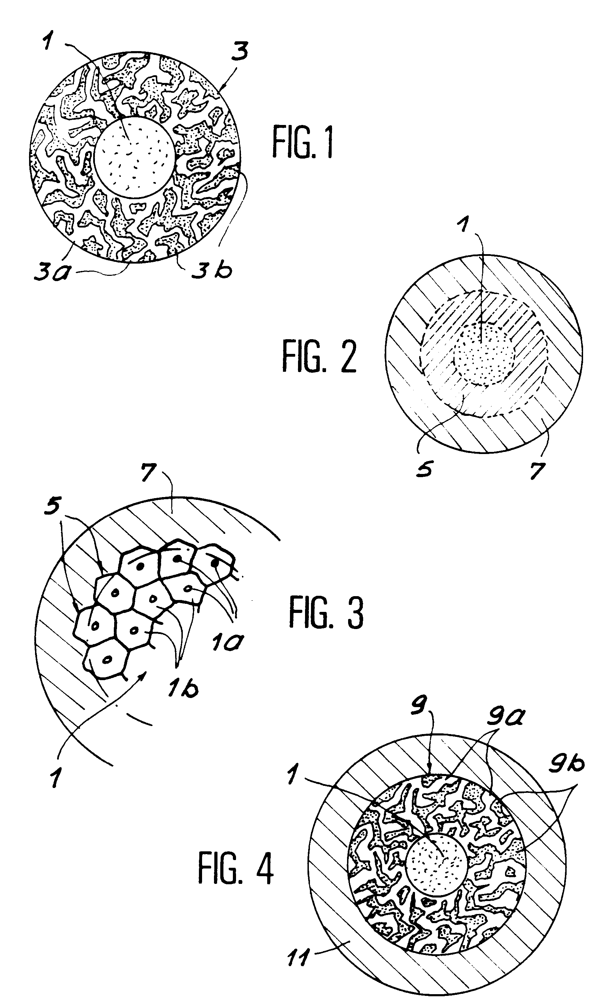

Cet exemple illustre la fabrication d'un élément composite supraconducteur utilisant une enveloppe composite non poreuse, conforme au premier mode de réalisation de l'invention représenté sur la figure 1.

Sur cette figure, on voit que l'élément comprend un coeur (1) en matériau supraconducteur et une enveloppe métallique (3) de structure composite comportant une première région (3a) et une deuxième région (3b).

La première région (3a) peut être formée d'un métal ou alliage perméable au gaz à diffuser, constituant également une barrière chimique entre le coeur (3) et la deuxième région (3b). On peut aussi utiliser pour la première région (3a) un métal ou alliage poreux ayant les propriétés voulues pour constituer également une barrière chimique.

Dans cet exemple, l'enveloppe métallique (3) est réalisée à partir d'une trame d'acier inoxydable à 18% de chrome et 8% de nickel obtenue par frittage naturel d'une poudre que l'on remplit d'argent par fusion. Ainsi, la première région est constituée par de l'argent et la deuxième région par de l'acier inoxydable. Ces deux régions forment des réseaux connectés dans le rapport volumétrique de 60/40. La région (3a) entoure complètement la région (3b) et dans cet exemple elle n'est pas poreuse, mais seulement perméable à l'oxygène.

L'enveloppe a la forme d'un tube de 9mm de diamètre externe et de 3mm d'épaisseur. On remplit ce tube d'une poudre d'YBaCuO supraconductrice précomprimée sous 20MPa, puis on ferme le tube à ses extrémités et on l'étire progressivement à froid jusqu'à un diamètre d'environ 1,5mm. On sépare plusieurs portions du fil obtenu, on ferme leurs extrémités et on réalise le traitement thermique de frittage avec un chauffage du four de 100°C/h.

Toutes les opérations sont réalisées sous un débit d'oxygène de 20ml/min sous $10^5$Pa. Le frittage est effectué pendant 4 heures à 930°C, puis la température du four est descendue à la vitesse de 100°C/h jusqu'à 450°C, et maintenue à cette température pendant 3 heures. On arrête alors le chauffage tandis que le balayage sous oxygène persiste jusqu'à 200°C.

L'analyse par rayons X montre que le matériau de coeur est $Y_1Ba_2Cu_3O_{6,8}$ de structure orthorhombique, supraconducteur à 90K. Les grains n'ont pas d'orientation préférentielle. La densification sur la céramique est d'environ 80%, et il est observé des cavités dans le coeur du matériau supraconducteur. La densité de courant critique mesurée à 77K est d'environ 100A/cm² avec le critère de 1µV/cm.

2°/ Traitements de frittage et de diffusion sous pression isostatique.

Dans ce cas, le fil est tout d'abord soumis à une compression isostatique pendant 1h à 940°C sous 100MPa d'un mélange gazeux argon-oxygène à 95 : 5. On fait décroître de façon simultanée la température et la pression pour atteindre $10^5$Pa à 350°C et on soumet alors l'enceinte jusqu'au complet refroidissement du four à un balayage en oxygène à la pression atmosphérique, sous un débit de 20ml/min. L'étape de réoxygénation du fil supraconducteur est réalisée avec un palier à la température de 350°C pendant 5 heures.

L'examen micrographique montre que la densification de YBaCuO est supérieure à 90% et que l'enveloppe enserre complètement la céramique sans laisser d'espace vacant. D'autre part, les grains montrent une orientation préférentielle le long de l'axe du fil. L'examen aux rayons X révèle que le matériau de coeur est $Y_1Ba_2Cu_3O_{7-\delta}$ avec δ = 0,1 à 0,2 de structure orthorhombique. Ceci indique un bon remplissage par l'oxygène du plan de base de YBaCuO. D'autre part les grains ont une orientation préférentielle avec le plan CuO selon la direction du fil, ce qui est favorable au passage du courant. Le courant critique à 77K de cet élément supraconducteur composite est de 300 A/cm². Le fil ainsi obtenu a de bonnes propriétés mécaniques et présente un comportement élastique à la flexion.

Dans un autre essai, on opère de la même façon que précédemment, mais la pression isostatique de 100MPa est maintenue sur le fil jusqu'à 350°C, température à laquelle la phase gazeuse est remplacée par de l'oxygène sous 10⁵Pa.

Le courant critique n'est pas changé de façon significative, mais le filament supraconducteur se trouve maintenu en compression radiale d'une façon plus efficace que dans l'essai antérieur. La limite élastique du fil s'en trouve renforcée.

## Exemple 2.

Cet exemple illustre la fabrication d'un fil composite supraconducteur conforme à la variante du premier mode de réalisation de l'invention, obtenu en partant d'une poudre supraconductrice d'YBaCuO. Cette poudre fine ne comporte d'après les rayons X que la seule phase cristallisée $Y_1Ba_2Cu_3O_{7-\delta}$ avec $\delta$ = 0,1 et la taille granulométrique est centrée autour de 2μm.

On précompacte la poudre en un barreau de 4mm de diamètre et de 3cm de longueur sous une pression de 50MPa.

On dispose d'autre part d'un tube métallique poreux composite, formé d'un fritté de nickel ayant des pores d'une taille d'environ 100um recouverts d'une couche chimique d'argent. Les dimensions du tube métallique sont des diamètres de 4 et 6mm et une longueur de 3,5cm ; les pores de ce tube poreux sont de l'ordre des 5-20μm.

On introduit le barreau précompacté dans le tube que l'on ferme à ses 2 extrémités, puis on l'étire jusqu'à un diamètre extérieur de 1,2mm, soit une réduction de section de 25 : 1.

On réalise ensuite les traitements suivants :
- frittage à 920°C pendant 12 heures sous circulation d'oxygène dans le four puis,
- la température du four étant abaissée de 920 à 500°C à la vitesse de 100°C/h, traitement de recuit à 500°C pendant 6h sans interrompre le balayage d'oxygène jusqu'à la fin du traitement, arrêt du chauffage du four, et maintien du fil composite dans le four jusqu'à la fin de son refroidissement naturel.

Après ces opérations, on protège le fil composite supraconducteur contre l'action de l'atmosphère par une gaine synthétique obtenue par polymérisation d'un film de résine époxy-acrylate de 100μm d'épaisseur sous rayonnement ultraviolet (lampe de 2KW).

La coupe transversale du fil composite montre que sur le diamètre externe de la céramique, la poudre YBaCuO a pénétré dans les pores du tube sur une profondeur d'au moins 10μm. La porosité de la céramique YBaCuO est d'environ 15%.

La transition supraconductrice mesurée par R(T) est de 92K avec une largeur $\Delta T_c$ de 3K. La densité de courant critique est de 120 A/cm² à 77K avec le critère de 1μV/cm.

## Exemple comparatif 1.

Cet exemple décrit la fabrication d'un fil supraconducteur composite en gaine d'argent par le procédé de l'art antérieur. Dans ce cas, le matériau YBaCuO est préparé par réaction à l'état solide de la façon suivante. On mélange soigneusement et on broie finement des poudres de $Y_2O_3$, de $BaCO_3$ et de CuO anhydres prises en proportions stoechiométriques, puis on les place dans un creuset en platine et on les chauffe sous air à 930°C dans un four ventilé pendant 9 heures. La poudre est alors rebroyée finement et ces opérations de broyage et de grillage sont répétées 2 fois. Après cette dernière opération, le four est balayé par de l'oxygène à la pression atmosphérique, et la température est abaissée à la vitesse de 100°C/h jusqu'à la température de 500°C. L'échantillon est maintenu ainsi dans le four pendant 6 heures, après quoi le four est refroidi naturellement.

La poudre obtenue est caractérisée par rayons X comme étant $Y_1Ba_2Cu_3O_{6,9}$ de structure orthorhombique avec les paramètres suivants :

a=0,382nm b=0,389nm et c=1,168nm.

Le matériau est supraconducteur avec une transition à 92K déterminée par susceptibilité magnétique. La taille moyenne des cristallites est d'environ de 10 à 20μm.

On remplit de cette poudre un tube d'argent de 6mm de diamètre externe et de 2mm d'épaisseur, on scelle le tube à ses deux extrémités et on l'étire à froid jusqu'à un diamètre de 1,2mm sans recuit intermédiaire. Ce fil est alors soumis à un traitement thermique de frittage à 930°C pendant 12 heures, puis à un recuit à 500°C pendant 5 heures sous courant d'oxygène à 30ml/min.

Le courant critique de ce fil mesuré par la méthode standard à 4 points sous champ magnétique externe nul à la température de 77K est de 60 A/cm² calculé avec un critère de 1uV/cm. On précise que la mesure porte sur un tronçon de fil de quelques cm de longueur soigneusement préservé de toutes manipulations de déformation du composite.

Au vu de ce résultat, on constate que le fait d'utiliser selon l'invention une enveloppe composite en acier inoxydable et en argent au lieu d'un tube d'argent permet d'améliorer de façon importante le courant critique de l'élément.

## Exemple 3.

Cet exemple illustre la fabrication d'un élément composite supraconducteur conforme au deuxième mode de réalisation de l'invention représenté sur la figure 2.

Sur cette figure, on voit que l'élément composite comprend un coeur (1) en matériau supraconducteur disposé dans une enveloppe métallique formée de deux couches concentriques (5) et (7). Conformément au deuxième mode de réalisation de l'invention, la couche (5) est constituée d'un métal ou d'un alliage autorisant le passage du gaz à diffuser et constituant une barrière chimique entre le coeur (1) et la deuxième région (7) qui forme une couche concentrique autour de la première région (5).

Ainsi, la première région (5) peut être constituée par un métal ou alliage, non poreux mais perméable au gaz à diffuser, ayant les caractéristiques voulues pour constituer une barrière chimique. On peut aussi réaliser la première région (5) en métal ou alliage poreux ayant les propriétés voulues pour constituer la barrière chimique. La deuxième région (7) est réalisée en métal ou alliage assurant la tenue mécanique.

Dans cet exemple, la première région (5) est réalisée en argent non poreux et la deuxième région (7) en acier inoxydable poreux. Cette enveloppe peut être fabriquée de la façon suivante.

On dispose sur une âme en laiton refroidie d'un diamètre de 6mm, un tube d'argent de 6 et 8mm de diamètre et on réalise sur ce tube d'argent un dépôt d'acier inoxydable poreux par projection plasma pour porter le diamètre du tube à 10mm. La porosité de la couche d'acier inoxydable est d'environ 10% et le rayon de pore moyen de quelques um.

On remplit ensuite le tube de la même poudre supraconductrice que celle de l'exemple 1, puis on le ferme à ses deux extrémités et on l'étire jusqu'à obtenir un diamètre extérieur de 2mm. On réalise ensuite les traitements thermiques selon la technique suivante :

1°) traitement classique de l'art antérieur.

Les fils sont chauffés dans un four sous air à 940°C ayant une vitesse de montée de 100°C/h. La température est maintenue pendant 6 heures à 940°C, puis le four est balayé par de l'oxygène sous la pression de $10^5$Pa avec un débit de 20ml/h pendant le refroidissement du four à la vitesse de 100°C/h jusqu'à un palier à 350°C qui est tenu pendant 3 heures. Le chauffage est alors coupé, le four refroidissant naturellement et le balayage par l'oxygène étant maintenu jusqu'à la température de 200°C.

Les examens par rayons X montrent que le matériau de coeur est $Y_1Ba_2Cu_3O_{6,8}$ de structure orthorhombique, supraconducteur à 90K. Le coefficient de remplissage interne de l'enveloppe qui tient compte de la porosité du supraconducteur et des lacunes entre enveloppe et matériau de coeur est d'environ 75%. Le courant critique de ce fil est d'environ 120A/cm² à 77K. Les grains du supraconducteur ne montrent pas d'orientation préférentielle.

2°) Traitement sous pression uniaxiale.

Des essais ont lieu successivement sur des tronçons de fil de 10cm de long fermés à leurs extrémités. Ces éléments sont placés entre les mâchoires en céramique préformées à la section du fil ; ces mâchoires constituent les éléments de serrage d'une presse uniaxiale. On élève à la vitesse de 100°C/h la température des pièces de serrage et des fils, jusqu'à atteindre 940°C. L'opération est conduite sous air, et est couplée avec l'élévation de la pression qui est maintenue pendant 2 heures à 940°C, et au cours du refroidissement jusqu'à 500°C. La pression est relâchée progressivement à partir de 500°C, l'air du four est chassé par un courant d'oxygène à la pression de $10^5$Pa et sous un débit de 20 ml/min. La température est maintenue à 350°C pendant 3 heures, Le chauffage est alors coupé, le four refroidit naturellement. Les pressions atteintes au cours de différents essais sont de 100 à 200 MPa.

La coupe transversale de ces fils permet d'observer la pénétration partielle de l'argent dans les pores de l'acier inoxydable, qui est due au fluage de l'argent au cours des traitements thermiques sous pression. L'enveloppe assure un bon contact avec le supraconducteur qui est identifié aux rayons X comme étant $Y_1Ba_2Cu_3O_{6,8}$ de structure orthorhombique avec le plan des CuO parallèle à l'axe du fil. A cause de la pression uniaxiale la gaine prend une forme ovoïde imprimée par les mâchoires. Le courant critique à 77K est estimé respectivement à 350 et à 400A/cm² pour les essais sous des pressions de 100 et 200MPa. Cette technique permet d'obtenir un fil supraconducteur qui présente un comportement élastique, ce qui n'affecte pas le courant supraconducteur.

Sur la figure 3, on a illustré un élément composite conforme à la variante du deuxième mode de réalisation.

Sur cette figure, on voit que l'élément composite comprend un coeur (1) en matériau supraconducteur (limité par la courbe en traits mixtes) disposé dans une enveloppe comportant deux couches concentriques (5) et (7). La couche (5) est constituée par un métal ou un alliage autorisant le passage du gaz à diffuser et constituant une barrière chimique entre le coeur (1) et la couche (7). La couche (7) est réalisée en métal ou alliage présentant une porosité ouverte.

Le coeur (1) est constitué de plusieurs éléments en matériau supraconducteur (1a) séparés par un métal ou alliage perméable au gaz (1b) qui est généralement identique à celui constituant la couche (5).

Cet élément peut être obtenu par assemblage de filaments élémentaires (1a) gainés du métal ou de l'alliage perméable au gaz à diffuser destiné à former la première région.

Selon l'invention, on peut aussi utiliser un coeur en matériau supraconducteur formé d'éléments supraconducteurs séparés par un métal ou alliage perméable aux gaz avec les enveloppes composites des premier et troisième modes de réalisation de l'invention.

Dans tous les cas, on assemble des tubes métalliques perméables aux gaz remplis de poudre que l'on introduit ensuite dans une enveloppe réalisée :
- soit en métal poreux pour former la seconde région dans le cas de la figure 3 (variante du deuxième mode de réalisation),
- soit en composite comme l'enveloppe (3) de la figure 1 (variante du premier mode de réalisation),
- soit formée de deux couches concentriques ayant les mêmes structures que les couches 9 et 11 de la figure 3 (variante du troisième mode de réalisation).

De préférence, pour accroître le facteur de remplissage en phase supraconductrice dans ces conducteurs multifilamentaires (c'est-à-dire la section totale des filaments supraconducteurs par rapport à la section totale du conducteur), on considère un assemblage de ces filaments, qui peuvent être au nombre de 30 à 100 et présenter après rétreint une taille de 0,01 à 0,1mm de diamètre, comme l'élément de coeur pour le procédé. Dans ce cas, l'enveloppe individuelle de ces filaments sera en un métal ductile simplement perméable au gaz. Dans le cas des oxydes mixtes de cuivre, un tel métal peut être de l'argent. Cet assemblage de fils dans leur première enveloppe, considéré comme un matériau de coeur, est soumis à un rétreint. Après cette première opération de rétreint, généralement ces assemblages sont rassemblés de nouveau pour constituer des conducteurs avec un nombre de filaments plus important par exemple de 100 à 1000.

Ensuite, on assure la tenue mécanique de l'ensemble du conducteur multifilamentaire par l'enveloppe externe poreuse (7). Dans un tel conducteur multifilamentaire, chacun des filaments aura une enveloppe faite d'un métal perméable au gaz à diffuser (poreux ou non), les assemblages des filaments seront réalisés par un métal perméable au gaz à diffuser, et l'enveloppe externe dans laquelle aura lieu le dernier rétreint sera le métal ou l'alliage poreux de la deuxième région comme dans le deuxième mode de réalisation.

## Exemple 4.

Cet exemple illustre la fabrication d'un élément composite conforme au troisième mode de réalisation de l'invention représenté sur la figure 4.

Sur cette figure, on voit que l'élément composite comprend un coeur (1) en matériau supraconducteur et une enveloppe comportant deux couches concentriques (9) et (11). La première couche concentrique (9) est formée d'une première région (9a) et d'une deuxième région (9b). La région (9a) permet de diffuser un gaz dans le matériau de coeur (1) et elle peut être constituée comme dans le cas de la figure 1, soit par un métal ou alliage poreux, soit par un métal ou alliage perméable au gaz à diffuser, tout en formant dans les deux cas une barrière chimique entre le matériau de coeur (1) et la région (9b) ainsi que la seconde couche (11). La région (9b) est constituée par un métal assurant la tenue mécanique de l'ensemble qui est complètement enrobé par la région (9a).

La seconde couche concentrique (11) est réalisée en métal ou alliage poreux et permet également d'assurer la tenue mécanique de l'ensemble.

Dans cet exemple, la première région (9a) est constituée d'argent, la deuxième région (9b) est de l'acier inoxydable et la troisième région (11) est en acier inoxydable poreux. L'enveloppe composite peut être réalisée à partir d'un tube (9) réalisé comme dans l'exemple (1) par infiltration d'argent dans un tube poreux en acier inoxydable, en recouvrant le tube d'une couche d'acier inoxydable poreux (11) en suivant le même mode opératoire que dans l'exemple 3. Le diamètre externe du tube obtenu est de 9mm et son diamètre interne de 6mm. On introduit ensuite la même poudre de YBaCuO que dans l'exemple 1 et on suit le même mode opératoire que dans l'exemple 1 pour effectuer les opérations de rétreint et de traitement thermique.

On obtient ainsi un fil supraconducteur avec un courant critique de 90A/cm$^2$ à 77K avec le critère de 1$\mu$V/cm , lorsque le traitement de frittage est réalisé à la pression atmosphérique et de 250A/cm$^2$ lorsque le traitement de frittage est réalisé sous pression isostatique.

## Exemple 5.

Cet exemple concerne la fabrication d'un fil composite supraconducteur conforme au deuxième mode de réalisation de l'invention dans lequel l'enveloppe est entièrement poreuse. Dans ce cas, la couche (5) est en alliage Pt-Pd en proportion de 80 : 20 et a une porosité de 30% ; la couche (7) est en acier inoxydable avec une porosité de 10%. Les diamètres interne et externe du tube sont de 4 et 6mm.

Le tube est rempli de poudre YBaCuO supraconductrice, puis fermé par pincement à ses extrémités, et soumis aux opérations de rétreint jusqu'à un diamètre de 1,4mm.

Les traitements thermiques sont ceux de l'exemple 3. Comme précédemment la céramique correspond à YBaCuO supraconducteur, et le courant critique est de 150 A/cm$^2$ à 77K avec le critère de 1$\mu$V/cm.
- Pour le fil soumis à une pression uniaxiale de 200MPa, la coupe métallographique montre une compacité meilleure que 95% sans vide entre la céramique et l'intérieur de l'enveloppe. Le courant critique à 77K sous champ nul est de 420 A/cm$^2$.

### Exemple 6.

Cet exemple illustre la réalisation d'un supraconducteur à partir de cristaux orientés.

On fabrique tout d'abord des cristaux de $Y_1Ba_2Cu_3O_6$ sous forme de plaquettes par refroidissement lent d'un mélange de $Y_2O_3$, $BaCO_3$ et $CuO$ porté à 1100°C, dans lequel on a introduit un excès de $Y_2O_3$ et $CuO$ par rapport à la stoechiométrie. Ces plaquettes ont les dimensions suivantes : longueur 1 à 2mm, épaisseur : 0,1mm, largeur : 0,3 à 0,5mm. La plus grande surface de ces plaquettes correspond aux plans $CuO_2$ de YBaCuO, c'est-à-dire le plan favorable au passage des supracourants quand la céramique est $Y_1Ba_2Cu_3O_{7-\delta}$ supraconductrice.

L'enveloppe qui est conforme au deuxième mode de réalisation de l'invention est réalisée de la façon suivante. Un ruban d'argent est plié en forme de U dans le sens de la longueur. Les cristaux sont déposés le long de cette gouttière à laquelle on imprime des mouvements vibratoires destinés à favoriser la répartition à plat des cristaux. Les côtés de cette gouttière sont repliés sur les cristaux. Ce cylindre est recouvert d'une couche de nickel poreux par projection, puis laminé sous la forme d'un ruban dont l'épaisseur correspond à l'empilement des cristaux les uns sur les autres.

Les traitements thermiques effectués conformément à l'exemple 3 montrent que les courants critiques sont dans la plage des 300 à 500A/cm$^2$ à 77K avec le critère 1µV/cm., sans dégager d'effet significatif sur le rôle de la pression uniaxiale dans les essais entrepris.

### Exemple 7.

Cet exemple illustre la fabrication d'un composite supraconducteur avec une orientation préférentielle des cristaux obtenue par un champ magnétique.

On prépare tout d'abord des cristaux de supraconducteur $Y_1Ba_2Cu_3O_{6,8}$ dont le diamètre des grains est typiquement de 5um. On prépare d'autre part un tube composite coaxial argent-acier inoxydable poreux non magnétique, comme cela a été décrit dans l'exemple 3. Le tube fermé à son extrémité inférieure est tenu verticalement. Il est placé dans un champ magnétique uniforme de 10T. La poudre de supraconducteur est introduite de façon continue sous une forme fluide avec un faible débit dans le tube non magnétique placé dans ce champ uniforme. De cette façon, on remplit entièrement le tube. Pour améliorer le coefficient de remplissage en cristaux, le tube est placé sur une table vibrante ; on effectue des compressions régulières de la poudre par un piston introduit dans le tube. Le tube plein est enfin fermé, puis soumis à un étirage classique jusqu'à un diamètre de 1,5mm.

Les traitements thermiques sont réalisés conformément au 1°) de l'exemple 3. Le filament ainsi obtenu est supraconducteur et correspond à $Y_1Ba_2Cu_3O_{6,8}$ avec une transition à 92K ; les grains ont une orientation préférentielle dans la gaine, et sont disposés avec les plans $CuO_2$ parallèles à l'axe du filament. Le courant critique mesuré sur ce fil à 77K est de 250A/cm$^2$.

Dans un autre essai on réalise les traitements thermiques du 2°) de l'exemple 3 avec une pression de 100MPa maintenue jusqu'à 350°C. Le courant critique est estimé à 450A/cm$^2$.

L'introduction de la poudre dans le tube sous un champ magnétique perpendiculaire à son axe, permet ainsi par l'orientation des grains d'améliorer les densités de supracourants critiques.

## Revendications

1. Elément composite comportant un coeur (1) en matériau supraconducteur céramique capable de devenir supraconducteur et une enveloppe métallique (3) disposée autour du coeur, caractérisé en ce que l'enveloppe a une structure composite autorisant la pénétration à travers celle-ci d'un gaz à diffuser dans le coeur et en ce qu'elle comprend au moins deux régions réalisées en des métaux ou des alliages différents, l'une des régions dite première région (3a) formant une barrière chimique entre le coeur et la ou les autres régions (3b), et la ou les autres régions ayant des modules d'élasticité plus élevés que ceux du matériau supraconducteur, à condition que cette structure composite ne soit pas constituée par deux couches concentriques dont une première couche en métal ou alliage non poreux, perméable au gaz à diffuser, disposée autour du coeur, et une deuxième couche présentant une porosité ouverte.

2. Elément selon la revendication 1, caractérisé en ce que l'enveloppe comprend deux régions, une première région (3a) constituée par un métal ou un alliage non poreux, perméable au gaz à diffuser et une seconde région (3b) dispersée à l'intérieur de la première région.

3. Elément composite selon la revendication 1, caractérisé en ce que l'enveloppe comprend deux régions, une première région (3a) présentant une porosité ouverte et une seconde région (3b) dispersée dans la première région.

4. Elément composite selon la revendication 1, caractérisé en ce que l'enveloppe comprend deux régions disposées en couches concentriques autour du coeur, la première région (5) formant une première couche à porosité ouverte en contact avec le coeur et la deuxième région (7) formant une seconde couche autour de la première couche et présentant une porosité ouverte.

5. Elément composite selon la revendication 1, caractérisé en ce que l'enveloppe comprend trois régions dont une première et une deuxième régions agencées entre elles pour former une première couche (9) entourant le coeur du matériau semiconducteur et une troisième région (11) présentant une porosité ouverte et formant une seconde couche autour de la première couche.

6. Elément composite selon l'une quelconque des revendications 2 à 5, caractérisé en ce que le coeur en matériau supraconducteur (1) est formé de plusieurs éléments (1a) en matériau supraconducteur séparés les uns des autres par un métal ou alliage perméable au gaz à diffuser (1b).

7. Elément composite selon la revendication 5, caractérisé en ce que la première région est en métal ou alliage, non poreux, perméable au gaz à diffuser et en ce que la deuxième région est dispersée dans la première région.

8. ELément composite selon la revendication 5, caractérisé en ce que la première région présente une porosité ouverte et en ce que la deuxième région est dispersée dans la première région.

9. Elément composite selon l'une quelconque des revendications 1, 3, 4 et 8, caractérisé en ce que la première région est réalisée en or, en argent, en palladium, en platine ou en leurs alliages.

10. Elément composite selon l'une quelconque des revendications 2 et 7, caractérisé en ce que le gaz à diffuser étant l'oxygène, la première région est réalisée en argent ou en alliage d'argent.

11. Elément composite selon l'une quelconque des revendications 1 à 10, caractérisé en ce que la deuxième région est en acier inoxydable, en fer, en nickel, en cuivre, en molybdène, en tungstène, en vanadium, en tantale, en rhénium, en rhodium, en iridium, en ruthénium ou en leurs alliages.

12. Elément composite selon l'une quelconque des revendications 7 à 9, caractérisé en ce que la troisième région est réalisée en acier inoxydable, en fer, en nickel, en cuivre, en molybdène, en tungstène, en vanadium, en tantale, en rhénium, en rhodium, en iridium, en ruthénium ou en leurs alliages.

13. Elément composite selon l'une quelconque des revendications 9 à 12, caractérisé en ce que le matériau supraconducteur est constitué par un oxyde mixte de cuivre.

14. Elément composite selon la revendication 13, caractérisé en ce que la deuxième région est réalisée en acier inoxydable, en alliage nickelchrome ou en alliage nickel-cuivre.

15. Elément composite selon l'une quelconque des revendications 1 à 14, caractérisé en ce qu'il comprend de plus une gaine imperméable aux gaz disposée autour de l'enveloppe métallique.

16. Procédé de fabrication d'un élément composite selon l'une quelconque des revendications 1 à 15 comportant un coeur en matériau supraconducteur céramique et une enveloppe métallique, caractérisé en ce qu'il comprend les étapes successives suivantes :

1°) introduire une poudre d'un matériau supraconducteur ou une poudre capable ce former un matériau supraconducteur dans un tube métallique composite au travers duquel peut pénétrer un gaz apte à conférer à la poudre les propriétés de supraconductivité voulues, le tube comportant au moins deux régions réalisées en des métaux ou alliages différents, l'une des régions dite première région formant une barrière chimique entre la poudre introduite dans le tube et la ou les autres régions du tube, et la ou les autres régions ayant des modules d'élasticité supérieurs à ceux du matériau supraconducteur,

2°) sceller le tube à ses deux extrémités,

3°) soumettre le tube à un rétreint pour former l'élément composite, et

4°) soumettre l'élément composite à un premier traitement thermique pour fritter la poudre de matériau supraconducteur, et à un second traitement de diffusion du gaz apte à conférer à la poudre les propriétés de supraconductivité voulues.

17. Procédé selon la revendication 16, caractérisé en ce que l'on applique une pression à l'élément composite lors du premier traitement thermique de frittage et/ou lors du second traitement de diffusion.

18. Procédé selon la revendication 16, caractérisé en ce que l'on applique un champ magnétique au tube lors de l'introduction de la poudre pour orienter les grains de poudre.

**Patentansprüche**

1. Zusammengesetztes Element mit einem Herzstück (1) aus keramischem, supraleitendem Material, das in der Lage ist, supraleitend zu werden, und einer metallischen Hülle (3), die um das Herzstück herum angeordnet ist, dadurch gekennzeichnet, daß die Hülle eine zusammengesetzte Struktur besitzt, die das Eindringen eines in das Herzstück zu diffundierenden Gases durch dieselbe erlaubt, und daß sie wenigstens zwei Bereiche aus zwei verschiedenen Metallen oder Legierungen umfaßt, wobei der eine der Bereiche, erster Bereich (3a) genannt, eine chemische Barriere zwischen dem Herstück und dem anderen Bereich oder den anderen Bereichen (3b) bildet und der andere Bereich oder die anderen Bereiche größere Elastizitätsmodule als die des supraleitenden Materials besitzen, vorausgesetzt daß diese zusammengesetzte Struktur nicht aus zwei konzentrischen Schichten besteht, von denen eine erste Schicht aus nicht-porösem Metall oder aus einer nicht-porösen Legierung, die für das zu diffundierende Gas durchlässig ist, um das Herzstück angeordnet ist und eine zweite Schicht eine offene Porosität aufweist.

2. Element nach Anspruch 1, dadurch gekennzeichnet, daß die Hülle zwei Bereiche umfaßt, wovon ein erster Bereich (3a) aus einem nicht-porösen Metall oder einer nicht-porösen Legierung besteht, die für das zu diffundierende Gas durchlässig sind, und der zweite Bereich (3b) im Inneren des ersten Bereichs verteilt ist.

3. Zusammengesetztes Element nach Anspruch 1, dadurch gekennzeichnet, daß die Hülle zwei Bereiche umfaßt, von denen der erste Bereich (3a) eine offene Porosität aufweist und der zweite Bereich (3b) in dem ersten Bereich verteilt ist.

4. Zusammengesetztes Element nach Anspruch 1, dadurch gekennzeichnet, daß die Hülle zwei Bereiche umfaßt, die in konzentrischen Schichten um das Herzstück angeordnet sind, wobei der erste Bereich (5) eine erste Schicht mit einer offenen Porosität im Kontakt mit dem Herzstück und der zweite Bereich (7) eine zweite Schicht um die erste Schicht herum bildet und eine offene Porosität aufweist.

5. Zusammengesetztes Element nach Anspruch 1, dadurch gekennzeichnet, daß die Hülle drei Bereiche umfaßt, von denen ein erster und ein zweiter Bereich zwischeneinander geformt sind, um eine erste, das Herzstück aus supraleitendem Material umgebende Schicht (9) zu bilden, und ein dritter Bereich (11) eine offene Porosität aufweist und eine zweite Schicht um die erste Schicht bildet.

6. Zusammengesetztes Element nach einem der Ansprüche 2 bis 5, dadurch gekennzeichnet, daß das Herzstück aus supraleitendem Material (1) aus mehreren Elementen (1a) aus supraleitendem Material besteht, die voneinander durch ein Metall oder eine Legierung getrennt sind, die für ein zu diffundierendes Gas (1b) durchlässig sind.

7. Zusammengesetztes Element nach Anspruch 5, dadurch gekennzeichnet, daß der erste Bereich aus einem nicht-porösen Metall oder einer nicht-porösen Legierung besteht, die für das zu diffundierende Gas durchlässig sind, und daß der zweite Bereich in dem ersten Bereich verteilt ist.

8. Zusammengesetztes Element nach Anspruch 5, dadurch gekennzeichnet, daß der erste Bereich eine offene Porosität aufweist und daß der zweite Bereich in dem ersten Bereich verteilt ist.

9. Zusammengesetztes Element nach einem der Ansprüche 1, 3, 4 und 8, dadurch gekennzeichnet, daß der erste Bereich aus Gold, Silber, Palladium, Platin oder ihren Legierungen hergestellt ist.

10. Zusammengesetztes Element nach einem der Ansprüche 2 und 7, dadurch gekennzeichnet, daß das zu diffundierende Gas Sauerstoff ist und der erste Bereich aus Silber oder einer Silberlegierung besteht.

11. Zusammengesetztes Element nach einem der Ansprüche 1 bis 10, dadurch gekennzeichnet, daß der zweite Bereich aus Edelstahl, Eisen, Nickel, Kupfer, Molybdän, Wolfram, Vanadium, Tantal, Rhenium, Rhodium, Iridium, Ruthenium oder ihren Legierungen besteht.

12. Zusammengesetztes Element nach einem der Ansprüche 7 bis 9, dadurch gekennzeichnet, daß der dritte Bereich aus Edelstahl, Eisen, Nickel, Kupfer, Molybdän, Wolfram, Vanadium, Tantal, Rhenium, Rhodium, Iridium, Ruthenium oder ihren Legierungen besteht.

13. Zusammengesetztes Element nach einem der Ansprüche 9 bis 12, dadurch gekennzeichnet, daß das supraleitende Material aus einem Kupfermischoxyd besteht.

14. Zusammengesetzes Element nach Anspruch 13, dadurch gekennzeichnet, daß der zweite Bereich aus Edelstahl, einer Nickel-Chrom-Legierung oder einer Nickel-Kupfer-Legierung besteht.

**15.** Zusammengesetztes Element nach einem der Ansprüche 1 bis 14, dadurch gekennzeichnet, daß es außerdem eine für die Gase undurchlässige Scheide um die metallische Hülle herum aufweist.

**16.** Verfahren zur Herstellung eines zusammengesetzten Elements nach einem der Ansprüche 1 bis 15, welches ein Herzstück aus einem supraleitenden, keramischen Material und eine metallische Hülle aufweist, dadurch gekennzeichnet, daß es die folgenden, sukzessiven Verfahrensschritte umfaßt:

1°) Einführen eines Pulvers eines supraleitenden Materials oder eines Pulvers, das in der Lage ist ein supraleitendes Material zu bilden, in eine zusammengesetzte, metallische Röhre, durch die ein Gas eindringen kann, das geeignet ist, dem Pulver die gewünschten supraleitenden Eigenschaften zu vermitteln, wobei die Röhre wenigstens zwei Bereiche aus zwei verschiedenen Metallen oder Legierungen umfaßt, wobei der eine der Bereiche, erster Bereich genannt, eine chemische Barriere zwischen dem in die Röhre eingeführten Pulver und dem anderen Bereich oder den anderen Bereichen der Röhre bildet und der andere Bereich oder die anderen Bereiche größere Elastizitätsmodule als die des supraleitenden Materials besitzen,

2°) Verschließen der Röhre an ihren beiden Enden,

3°) Unterwerfen des zusammengesetzten Elements einer ersten thermischen Behandlung, um das Pulver aus supraleitendem Material zu sintern, und einer zweiten Diffusionsbehandlung mit dem Gas, das geeignet ist, dem Pulver die gewünschten supraleitenden Eigenschaften zu vermitteln.

**17.** Verfahren nach Anspruch 16, dadurch gekennzeichnet, daß man während der ersten thermischen Sinterbehandlung und/oder während der zweiten Diffusionsbehandlung einen Druck an das zusammengesetzte Element anlegt.

**18.** Verfahren nach Anspruch 16, dadurch gekennzeichnet, daß man während des Einführens des Pulvers ein magnetisches Feld anlegt, um die Körner des Pulvers auszurichten.

## Claims

**1.** Composite element comprising a core (1) made of ceramic material which is superconductive or capable of becoming superconductive and a metal jacket (3) arranged around the core, characterized in that the jacket has a composite structure allowing a gas to be diffused into the core to pass through it and in that it includes at least two regions made of different metals or alloys, one of the regions, called first region (3a), forming a chemical barrier between the core and the other region(s) (3b), and the other region(s) having moduli of elasticity which are higher than those of the superconductive material, provided that this composite structure does not consist of two concentric layers including a first layer of nonporous metal or alloy, permeable to the gas to be diffused, arranged around the core, and a second layer exhibiting an open porosity.

**2.** Element according to Claim 1, characterized in that the jacket includes two regions, a first region (3a) consisting of a nonporous metal or alloy, permeable to the gas to be diffused and a second region (3b) dispersed inside the first region.

**3.** Composite element according to Claim 1, characterized in that the jacket includes two regions, a first region (3a) exhibiting an open porosity and a second region (3b) dispersed in the first region.

**4.** Composite element according to Claim 1, characterized in that the jacket includes two regions arranged in concentric layers around the core, the first region (5) forming a first layer with open porosity in contact with the core and the second region (7) forming a second layer around the first layer and exhibiting an open porosity.

**5.** Composite element according to Claim 1, characterized in that the jacket includes three regions including a first and a second region which are mutually arranged to form a first layer (9) surrounding the core of the semiconductive material and a third region (11) exhibiting an open porosity and forming a second layer around the first layer.

**6.** Composite element according to any one of Claims 2 to 5, characterized in that the core made of superconductive material (1) is formed by a number of elements (1a) made of superconductive material which are separated from one another by a metal or alloy which is permeable to the gas to be diffused (1b).

**7.** Composite element according to Claim 5, characterized in that the first region is made of nonporous metal or alloy, permeable to the gas to be diffused, and in that the second region is dispersed in the first region.

**8.** Composite element according to Claim 5, characterized in that the first region exhibits an open porosity and in that the second region is dispersed in the first region.

9. Composite element according to any one of Claims 1, 3, 4 and 8, characterized in that the first region is made of gold, silver, palladium, platinum or their alloys.

10. Composite element according to either of Claims 2 and 7, characterized in that, the gas to be diffused being oxygen, the first region is made of silver or silver alloy.

11. Composite element according to any one of Claims 1 to 10, characterized in that the second region is made of stainless steel, iron, nickel, copper, molybdenum, tungsten, vanadium, tantalum, rhenium, rhodium, iridium, ruthenium or their alloys.

12. Composite element according to any one of Claims 7 to 9, characterized in that the third region is made of stainless steel, iron, nickel, copper, molybdenum, tungsten, vanadium, tantalum, rhenium, rhodium, iridium, ruthenium or their alloys.

13. Composite element according to any one of Claims 3 to 12, characterized in that the superconductive material consists of a mixed copper oxide.

14. Composite element according to Claim 13, characterized in that the second region is made of stainless steel, nickel-chromium alloy or nickel-copper alloy.

15. Composite element according to any one of Claims 1 to 14, characterized in that it additionally includes a gas-impervious sheath arranged around the metal jacket.

16. Process for the manufacture of a composite element according to any one of Claims 1 to 15 comprising a core made of a ceramic superconductive material and a metal jacket, characterized in that it includes the following successive stages:
    1) introducing a powder of a superconductive material or a powder capable of forming a superconductive material into a composite metal tube through which a gas capable of imparting the desired superconductivity properties to the powder can penetrate, the tube comprising at least two regions made of different metals or alloys, one of the regions, called first region, forming a chemical barrier between the powder introduced into the tube and the other region(s) of the tube, and the other region(s) having moduli of elasticity which are higher than those of the superconductive material,
    2) sealing the tube at its two ends,
    3) subjecting the tube to a shrinkage to form the composite element, and
    4) subjecting the composite element to a first heat treatment to sinter the powdered superconductive material and to a second treatment for diffusion of the gas capable of imparting the desired superconductivity properties to the powder.

17. Process according to Claim 16, characterized in that a pressure is applied to the composite element during the first sintering heat treatment and/or during the second treatment for diffusion.

18. Process according to Claim 16, characterized in that a magnetic field is applied to the tube during the introduction of the powder to orient the powder particles.

FIG. 1

FIG. 2

FIG. 3

FIG. 4